# EUROPEAN PATENT SPECIFICATION

(11) **EP 1 606 863 B1**
(45) Date of publication and mention of the grant of the patent: **07.05.2008**
(21) Application number: 04722906.7
(22) Date of filing: 24.03.2004
(51) Int. Cl.: H01S 5/183, H01S 5/04, H01S 3/113, H01S 5/065

(54) **IMPROVEMENTS IN AND RELATING TO VERTICAL-CAVITY SEMICONDUCTOR OPTICAL DEVICES**
VERBESSERUNGEN OPTISCHER HALBLEITERVORRICHTUNGEN MIT VERTIKALEM RESONATOR
PERFECTIONNEMENTS DANS DES DISPOSITIFS OPTIQUES SEMICONDUCTEURS A CAVITE VERTICALE

(30) Priority: 24.03.2003 GB 0306798
(43) Date of publication of application: 21.12.2005
(73) Proprietor: University of Strathclyde, Glasgow G1 1XQ (GB)
(72) Inventor: CALVEZ, Stephane Luc Dominique, Glasgow G42 8TA (GB); HOPKINS, John-Mark, Queenspark, Glasgow G42 8RD (GB); BURNS, David, Glasgow G4 9TB (GB); DAWSON, Martin David, Bishopton, Renfrewshire PA7 5HR (GB)
(74) Representative: Critten, Matthew Peter
(86) International application number: PCT/GB2004/001233
(87) International publication number: WO 2004/086577

(56) References cited:
- WO-A-01/59895
- WO-A-02/47223
- US-A- 5 461 637
- RAJA M Y A ET AL: "RESONANT PERIODIC GAIN SURFACE-EMITTING SEMICONDUCTOR LASERS" IEEE JOURNAL OF QUANTUM ELECTRONICS, IEEE INC. NEW YORK, US, vol. 25, no. 6, 1 June 1989 (1989-06-01), pages 1500-1512, XP000054771 ISSN: 0018-9197 cited in the application
- GARNACHE A ET AL: "SUB-500-FS SOLITON-LIKE PULSE IN A PASSIVELY MODE-LOCKED BROADBAND SURFACE-EMITTING LASER WITH 100 MW AVERAGE POWER" APPLIED PHYSICS LETTERS, AMERICAN INSTITUTE OF PHYSICS. NEW YORK, US, vol. 80, no. 21, 27 May 2002 (2002-05-27), pages 3892-3894, XP001126674 ISSN: 0003-6951
- MICHLER P ET AL: "EMISSION DYNAMICS OF IN0.2GA0.8AS/GAAS LAMBDA AND 2 LAMBDA MICROCAVITY LASERS" APPLIED PHYSICS LETTERS, AMERICAN INSTITUTE OF PHYSICS. NEW YORK, US, vol. 68, no. 2, 8 January 1996 (1996-01-08), pages 156-158, XP000552697 ISSN: 0003-6951

## Description

This invention relates to the field of vertical-cavity semiconductor optical devices, in particular to devices such as Vertical-cavity Surface-emitting Lasers (VCSELs), Vertical extended-cavity Surface-emitting Lasers (VECSELs) (also known as semiconductor disk lasers) and Vertical-cavity Semiconductor Optical Amplifiers (VCSOAs).

Semiconductor lasers are by far the most common form of laser available in the world today. They are in general fabricated by depositing layers of semiconductor on a substrate material.

Pump energy may be supplied electrically or optically to a semiconductor laser to achieve a population inversion in the active region of the laser.

Most semiconductor lasers are Edge-emitting Lasers (EELs). In an EEL, an active region is formed by sandwiching a layer of semiconductor material having a lower bandgap energy between two layers of semiconductor materials having higher bandgap energies. The active region usually has a higher refractive index than the adjacent layers and so emitted light is confined by the index steps to the active region. An EEL thus emits light in a direction in the plane of the active region. Mirrors providing feedback for lasing action can be provided by various means, including cleaving the end-faces of the semiconductor wafer forming the laser or providing Bragg gratings in the plane of the active region.

A disadvantage of EELs is that they produce an output beam that is of relatively poor quality in some respects. The active region, viewed from the edge from which light is emitted is typically much wider than it is high. That asymmetry results in an asymmetric output beam. Although the small height of the active region usually results in a beam comprising a single transverse mode in the vertical direction, the larger width usually results in many transverse modes in the horizontal direction. This asymmetric, non-diffraction-limited output beam can make it difficult to use the diode output beam in many applications. Various ways of overcoming that problem have been implemented but all involve increased complexity of manufacture.

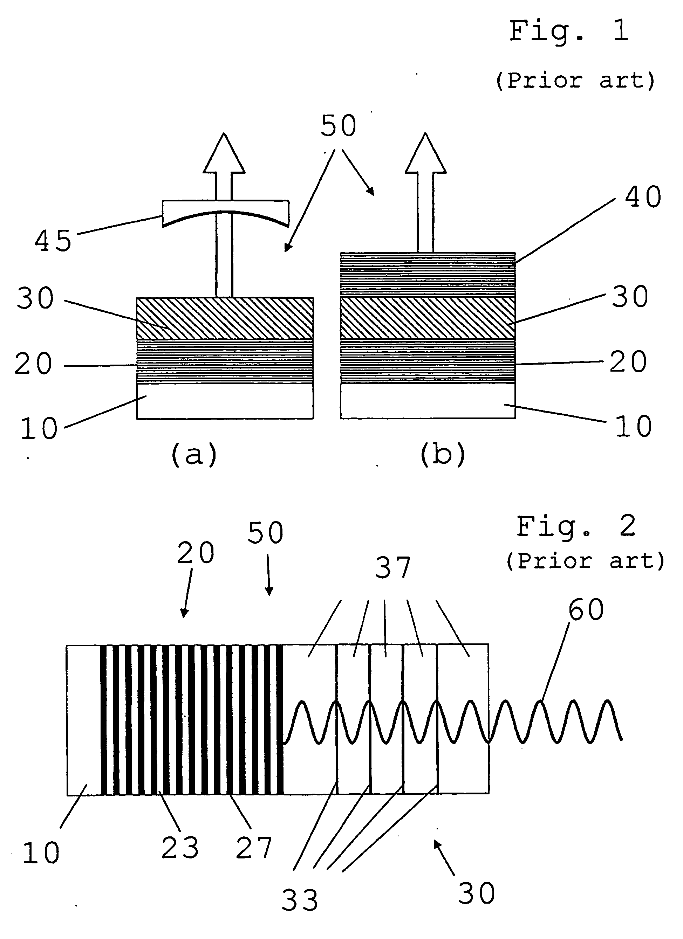

Vertical-cavity, surface-emitting lasers (VCSELs) are semiconductor lasers that, in contrast to EELs, emit light in a direction perpendicular to the plane of the active region (Fig. 1 (b)). Feedback is provided by reflectors in the form of distributed Bragg reflectors (DBRs) 20, 40, provided above and below active region 30, formed from alternating in the deposited structure thin layers of material of different refractive indices. (Devices have also been fabricated having reflectors comprising a metal layer and a small number of dielectric layers, the metal layer providing improved thermal performance.) The active region 30 usually includes one or more quantum wells that provide gain. As with EELs, the layers 20, 30, 40 are grown on a wafer substrate 10.

The DBRs 20, 40 consist of alternating quarter wavelength (optical thickness) layers of two or more optically transparent materials with a suitable refractive index contrast to provide a high degree of reflection at the signal (operating) wavelength. When grown monolithically DBR 20 is fabricated from semiconductor material layers on a semiconductor substrate with the subsequent half wavelength (or multiple thereof) laser cavity grown on the upper surface of this mirror 20. This cavity may contain an active region made of either bulk "gain layers" of active semiconductor or single or multiple thin layers of active semiconductor material (quantum wells) to provide optical absorption at the pump and device gain at the signal wavelength. These layers are surrounded by an appropriate thickness of "barrier" material to provide carrier confinement, additional pump absorption, and for the maximum gain enhancement appropriate spacing for the quantum wells in order to place them in the antinodes of the oscillating field for maximum gain extraction efficiency, a so-called resonant periodic gain (RPG) arrangement. The gain region may be surrounded by a non-absorbing confinement region to isolate carriers from the device surface and/or the mirror layers. DBR 40 is then fabricated by deposition of further suitable semiconductor material layers.

This semiconductor chip may be mounted on a suitable temperature-controlled heatsink.

VCSELs provide several advantages over EELs. The very short cavity length (which is approximately the height of the active region, typically ~1 micron) means that a VCSEL operates in a single longitudinal mode, as its mode spacing is greater than the gain bandwidth of the device. Viewed from the direction of emission, the active region is symmetric, in contrast to an EEL, and so it is much easier to achieve a circular, symmetric output beam. Moreover, use of a short (approximately one-half to fifteen times the wavelength λ of the emitted light) active region permits the symmetric beam to oscillate on a single longitudinal mode. VCSELs typically have low threshold powers for the onset of laser action and they typically have high modulation bandwidths. They are also very stable.

Vertical-cavity devices may be pumped optically or electrically. A disadvantage of electrical pumping is that a relatively complex structure is often necessary in the semiconductor chip in order to optimise delivery of current to the active region. In contrast, optical pumping may be achieved with a semiconductor chip having a relatively simple structure.

However, the output power available from a VCSEL is rather low, typically of the order of 1 mW. Whilst that is adequate in many applications, many more applications become available for a semiconductor laser emitting higher powers. The power available from an electrically pumped VCSEL is limited by the difficulty of maintaining a uniform current distribution and single-transverse-mode operation for large drive-current apertures.

Vertical Extended Cavity Surface Emitting Lasers (VECSELs) are a variation of the VCSEL concept that has been recently developed (M.A. Hadley, et al., "High single-transverse-mode output from external-cavity surface-emitting laser diodes," Appl. Phys. Lett. 63, 1607-1609 (1993)). In a VECSEL (Fig. 1(a)), one of the DBRs 40 is omitted from the device and feedback is provided instead by one or more optical substrates coated with highly reflective dielectric coatings at the signal wavelength (external mirror 45 in Fig. 1).

Pumping may be electrical or optical in the form of pump light provided by commercial diode lasers of suitable wavelength coupled to the device with suitable optics to provide a tight to moderate focus at the surface of the VECSEL chip.

With optical pumping, the VECSEL may act as a mode-converter. A pump diode having a relatively poor, multimode beam may be focused to a relatively tight focus in the active region of the chip, where the beam energy is absorbed and re-emitted in the VECSEL output beam, which is typically a high-quality, single-transverse-mode beam. Although the pump beam is not diffraction limited, and therefore diverges rapidly from a tight focus, the active region of the VECSEL is sufficiently short for that divergence not to be significant within the active region. Thus energy can be efficiently converted from the poor mode of the pump laser to the good mode of the VECSEL.

Use of an external mirror enables production of higher output powers by permitting single mode operation at larger pumping diameters. Continuous wave (CW) powers of over 0.5 W, and pulse peak powers of over 1 W, was achieved by M. Kuznetsov et al. ("High-power (>0.5 W CW) Diode-pumped Vertical-External-Cavity Surface-Emitting Lasers with Circular TEM00 Beams," IEEE Photonics Tech. Lett. 9, 1063-1065 (1997)); see also S. Hoogland et al., "Passively mode-locked diode-pumped Surface-emitting semiconductor laser", IEEE Photonics Tech. Lett. 12, 1135-1137 (2000).

Of course, a laser is essentially an optical amplifier that oscillates due to feedback. Power must be supplied to a laser device to create a population inversion, which provides gain. The power for a semiconductor laser is typically supplied optically or electrically. A certain amount of power (the laser threshold power) must be provided for the laser to lase (oscillate) and feedback must be provided. A laser device that does not include feedback (e.g. a VECSEL without a second mirror) or that is not provided with sufficient power for oscillation will act as an amplifier when light of a suitable wavelength is input into the device. Thus a laser device may be operated as a simple or regenerative amplifier, rather than as a laser. A VCSOA is an example of such an amplifier, typically being a VCSEL or VECSEL operated below its lasing threshold. The device of Fig. 1(a) is shown in more detail in Fig. 2 as an illustrative embodiment of the RPG concept. As explained above, the device comprises an external mirror 45 (not shown in Fig. 2) and a chip 50, which includes a substrate 10, a mirror 20 and an active semiconductor layer 30. The mirror 20 is a DBR formed of a plurality of layers 23, 27, with alternate layers 23, 27 being of semiconductor material having a higher and a lower refractive index respectively. Active region 30 includes four quantum wells 33, which provide optical gain. Quantum wells 33 are separated from each other and from mirror 20 by barrier regions 37.

In operation, signal light 60 is reflected back and forth between mirror 20 and mirror 45 and interference effects between different passes of the reflected light 60 forms a standing wave in the laser cavity. Barrier regions 37 are grown to a thickness selected to position quantum wells 33 at the antinodes of this standing wave of the signal light 60.

Mohammad Yasin A. Raja et al. describe in 'Resonant Periodic Gain Surface-emitting Semiconductor Lasers', IEEE J. Quantum Electron. Vol. 25, No. 6 pp 1500-1512 (June 1989) a vertical-cavity semiconductor laser structure comprising an active region comprising 'a series of quantum wells spaced at one half the wavelength of a particular optical transition in the quantum wells'. They go on to state that '[That] spatial periodicity allows the antinodes of the standing wave optical field to coincide with the gain elements, enhancing the frequency selectivity, increasing the gain in the vertical direction by a factor of two compared to a uniform medium or a nonresonant multiple quantum well and substantially reducing amplified spontaneous emission'. They note that 'Various other optoelectronic devices which depend on the interaction between an electromagnetic standing wave and a carrier population distribution can also benefit from this concept'. Examples of such devices given include 'amplifiers, modulators, wavelength- and phase-sensitive photodetectors, bistable etalons for low-threshold optical switching, saturable excitonic absorbers for mode-locking applications, self-electrooptic-effect devices (SEED's) and nonlinear elements for wave mixing and phase conjugation'.

In modern modelocked solid-state lasers, a semiconductor device which has generated much interest is the semiconductor saturable absorber mirror (SESAM) or saturable Bragg reflector (SBR) (see, for example, U. Keller, K. J. Weingarten, F. X. Kärtner, D. Kopf, B. Braun, I. D. Jung, R. Fluck, C. Hönninger, N. Matuschek, and J. Aus der Au., IEEE J of Sel Topics Quant Electron, 2, 3, 1996, p435). These devices incorporate a high-quality Bragg reflecting mirror structure in which has been grown an absorber region that absorbs at the wavelength of the mirror structure. A low intensity signal incident on the mirror experiences this absorption, so the reflection of the mirror is compromised to some degree. A high-intensity signal will quickly saturate the single absorber allowing the majority of the signal to experience the full reflectivity of the mirror structure. Such a device, placed in a laser cavity, provides a mechanism for differentiating and selecting between continuous-wave (cw) and modelocked or pulsed operation by providing a preferential gain window for a high intensity intra-cavity pulse. It also promotes self-starting modelocked operation. The pulse is allowed to build from any spontaneous emission and atmospheric noise within the cavity. There are many forms of such a device, all building on this basic principle.

WO 0247223 describes a vertical cavity laser device comprising: a multi-layer laser structure having a pump light receiving face for receiving incident pump light at a pump wavelength, and a semiconductor gain region operable to provide optical gain at a laser emission wavelength in response to the pump light; two laser cavity mirrors disposed about the multi-layer laser structure so as to define a laser cavity wherein each laser cavity mirror is operable to reflect light at the laser emission wavelength; and a pump mirror disposed behind the gain region so as to reflect pump light back through the gain region for at least a second pass.

An object of the invention is to provide an improved vertical-cavity device and a method of fabricating such an improved device.

Thus according to a first aspect of the invention there is provided an optical device, comprising:
(a) an active semiconductor region, for providing gain to signal light passing through said active region;
(b) a signal-light reflector, for reflecting the signal light through the active region in a direction out of the plane of the active region; and
(c) a pump-light reflector, the pump-light reflector being arranged to reflect pump light so as to form a standing wave in the device; and
(d) an absorber that absorbs light at a wavelength of the signal light;
characterised in that the absorber is arranged at a position in the device at which there is no or substantially no pump light.

The Mohammed Yasin A. Raja teaching relates to positioning a device element at an antinode of the signal light; however, the inventors have realised that it can be advantageous to position a signal-light absorber at a node of the pump light (the absorber may be arranged to be also at an antinode of the signal light, as discussed further below).

The device may be arranged to provide pulses of signal light. The pulses may be produced by modelocking the device using the absorber, which will in that case be a saturable absorber.

Thus, a saturable absorbing element may be incorporated into a vertical laser device to encourage or cause pulse production. Integrating the gain and pulse producing elements in a single (monolithic) device may advantageously provide a compact pulsed source, which is simple to align and which has (for example, in the case of a VECSEL-type structure) reduced external cavity complexity and a potentially high repetition rate. This idea builds on the resonant periodic absorption (RPA) enhancement approach (described below) in that the pump is reflected in order to produce a pump standing wave. RPA enhancement is desirable but not essential (although care should still be taken to ensure the pump-light absorbers in the gain region do not all lie at nodes of the pump field). Also RPG is also desirable in these devices; thus, the pump-light-absorbing element may be arranged at or near an anti-node in the signal standing wave.

When the pump forms a standing wave, it is possible to place absorber layers within the device at positions of near zero pump field. That allows the layers to absorb the signal and act as a saturable absorber at the signal wavelength as they are not saturated by the pump field, as they are effectively not pumped. The absorber may then act, for example, as a passive modelocking element or a gain-switching or modulation element. The absorber may be a saturable absorber, which may be a quantum well, which may be used, for example, to modelock the device, to produce a pulsed signal-light output.

The position of the absorber with respect to the signal field may be selected to specifically tailor the fluence at the absorber and therefore the properties of the device such as the modulation depth; the absorber need not necessarily be at an antinode of the signal light. It would also be possible in a semiconductor system to tailor growth conditions and materials used to form the absorber, to optimise the performance of the absorber within the device, for example to achieve a faster dynamic response or to change the non-saturable losses.

The active region, signal-light reflector and pump-light reflector may be comprised in a monolithic unit, which may be a semiconductor chip. The optical device may be, for example, a VCSEL, a VECSEL or a VCSOA or any other suitable device in which the signal light is reflected through the active region in a direction not in the plane of the active region. The signal light reflector may reflect light in a direction passing substantially perpendicularly through the active region.

The device may comprise a second signal-light reflector for reflecting the signal light back towards the signal-light reflector. Thus a resonant cavity may be provided for the signal light, providing multiple passes of the absorber.

The second signal-light reflector may provide a deliberately engineered or a latent reflection of the pump beam or may be provided by a device-air interface at a surface of the device. The signal-light reflector may comprise a stack comprising a plurality of layers having differing refractive indices, which may be a dielectric stack or a semiconductor stack. The stack may be a DBR.

The second signal-light reflector may be a dielectric stack or a semiconductor stack. The stack may be a DBR (to give a VCSEL-type structure, for example) or it may be a coating on an external mirror (to give a VECSEL-type structure, for example).

There may be one or more than one absorber.

The active region may comprise the absorber.

The signal light may form a signal standing-wave by reflection from the signal-light reflector. The absorber may be arranged at or near an anti-node in the signal standing-wave.

The device may comprise a second pump-light reflector for reflecting the pump light back towards the pump-light reflector. Thus a resonant cavity may be provided for the pump light, providing multiple passes of the gain region. The second pump-light reflector may provide a deliberately engineered or a latent reflection of the pump beam or may be provided by a device-air interface at a surface of the device. The second pump-light reflector may comprise a metal mirror or a dielectric stack.
The second pump light reflector may only partially reflect the pump light, in order that sufficient incoming pump light can pass through it. The second pump light reflector may be positioned such that the pump wavelength matches a longitudinal mode of the cavity formed between the pump light reflector and the second pump light reflector; in that case, pump light may be coupled into the cavity even if the second pump light reflector is highly reflecting at the wavelength of the pump light.

The pump-light reflector may comprise a metal mirror or a stack comprising a plurality of layers having differing refractive indices, which may be a dielectric stack or a semiconductor stack. The stack may be a DBR. The pump light reflector may be arranged in line with but further from the active region than the signal-light reflector. Similarly, the second pump light reflector may be arranged in line with but further from the active region than the second signal-light reflector.

Alternatively, the pump light reflector may be arranged in line with but closer to the active region than the signal-light reflector. Similarly, the second pump light reflector may be arranged in line with but closer to the active region than the second signal-light reflector.

Alternatively the pump-light reflector and the signal-light reflector may be comprised in a single structure. For example, the two reflectors may be formed by a DBR exhibiting two reflection bands. Alternatively, the pump wavelength may be chosen to be sufficiently close to the signal wavelength as to fit within a single reflection band. Thus reflections from at least the signal-light reflector and the second signal-light reflector may result in a cavity or sub-cavity resonance at a signal wavelength at which the active region provides gain and the device may further comprise a source of pump light at a pump wavelength, with the signal-light reflector also reflecting pump light at the pump wavelength. The inventors refer to this as 'close pumping' and it has the advantage of a low quantum defect and therefore greater efficiency and a potentially faster dynamic response of the device. In order to increase coupling efficiency of the pump (which is a significant consideration when the reflectivity of the top mirror is high at the pump wavelength), it is advantageous to pump at a wavelength corresponding to a Fabry-Perot resonance, 'resonant close pumping'. Thus, it may be that reflections from at least the signal-light reflector and the second signal-light reflector result in a cavity or sub-cavity resonance at the pump wavelength.

Obtaining more than one Fabry-Perot resonance within the reflector's reflection band, can be achieved by increasing the length of the active region (cavity or sub-cavity)or by broadening the reflection band of the reflector, for example, by oxidation to provide a wide band that spans more than one resonance. Combinations of those alternatives may also be used. The reflection of the pump also removes excess heat from the device due to parasitic pump absorption within the device or at the mirror substrate and substrate/heatsink boundaries. Thus a monolithic or composite laser structure may be fabricated with a bottom Bragg reflector (which may be distinct or exhibit a double reflectance band) that reflects the pump and signal, such that the pump field is in effect resonant and forms a standing wave.

An example of a method of supplying pump light to an optical device comprises:
(a) an active semiconductor region, for providing gain to signal light passing through said active region;
(b) a signal-light reflector, for reflecting the signal light through the active region in a direction passing out of the plane of the active region; and
(c) a second signal-light reflector;
wherein the method includes the step of supplying pump light to the device at a pump wavelength that is reflected by the signal light reflector.

An example of an optical device comprises:
(a) an active semiconductor region, for providing gain to signal light passing through said active region;
(b) a signal-light reflector, for reflecting the signal light through the active region in a direction out of the plane of the active region;
(c) a second signal-light reflector; and
(d) a pump-light reflector;
wherein the signal-light reflector is also the pump-light reflector and the device further comprises a second pump-light reflector, and wherein reflections from at least the signal-light reflector and the second pump-light reflector result in a second cavity or sub-cavity resonance at a pump wavelength.

Reflections from at least the signal-light reflector and the second signal-light reflector may result in a cavity or sub-cavity resonance at a signal wavelength at which the active region provides gain; it may be that the pump wavelength corresponds to a further cavity or sub-cavity resonance resulting from reflections from at least the signal-light reflector and the second signal-light reflector.

The inventors have realised that the properties of a vertical-cavity optical device may be engineered by localising absorption and then selecting the position of the localised absorption to control the absorber's interaction with pump light.

Another example of an optical device comprises:
(a) an active semiconductor region, for providing gain to signal light passing through said active region;
(b) a signal-light reflector, for reflecting the signal light through the active region in a direction out of the plane of the active region; and
(c) an absorber;
wherein the absorber is arranged in a position in the device that is selected to control absorption of pump light by the absorber.

An example of a method of engineering an optical device comprises:
(a) an active semiconductor region, for providing gain to signal light passing through said active region;
(b) a signal-light reflector, for reflecting the signal light through the active region in a direction out of the plane of the active region; and
(c) an absorber;
wherein the method comprises the step of controlling absorption of pump light by the absorber by selecting a position for the absorber in the device.

As discussed above, the position selected may be, for example, at an antinode of a pump standing wave. It may be a position in the device at which pump light is very low, minimal or zero, for example at a node of a pump standing wave or at a position in the device that is not reached by pump light, for example because the pump light is reflected before it reaches that position.

Another example of an optical device comprises:
(a) an active semiconductor region, for providing gain to signal light passing through said active region;
(b) a signal-light reflector, for reflecting the signal light through the active region in a direction out of the plane of the active region; and
(c)a pump-light reflector;
wherein the pump light reflector is arranged between the signal light reflector and the active region.

The device may further comprise an element for interacting with signal light in the device, the element being arranged between the pump light reflector and the signal light reflector. The element may be a saturable absorber. The pump-light reflection will of course in this case be highly transmissive at the signal wavelength.

Another example of an optical device comprises:
(a) an active semiconductor region, for providing gain to signal light passing through said active region;
(b) a signal-light reflector, for reflecting the signal light through the active region in a direction out of the plane of the active region;
(c) a pump-light reflector, the pump-light reflector being arranged to reflect pump light so as to form a standing wave in the device; and
(d) an element, arranged in the pump standing wave, that absorbs pump light to provide gain to the signal light,
wherein the element is arranged at or near to an antinode of the pump standing wave.

By creating a standing wave in the pump light within the device the efficiency of an interaction with the pump light may be immediately doubled. The element may be a quantum well. The element may be in the active semiconductor layer.

The creation of a resonant feature at the pump wavelength in an optically pumped device (which we call resonant periodic absorption - RPA) provides a potential for enhanced pump absorption. Assuming weak absorption, reflection of the pump light by the pump-light reflector immediately improves absorption efficiency. The amount of pump light absorbed is then determined by the position of the absorbing region or individual quantum wells within the resonant standing-wave pump field. The element may be arranged at the maximum field position to maximise the gain and therefore provide further pump absorption enhancement. The invention may thus provide more efficient devices due to pump enhancement by placing the active regions at the antinodes of a pump standing wave.

Thus, the element may be arranged at or near to an antinode of the pump standing wave. Arranging the gain element at an antinode of the pump standing wave will generally result in twice as much power being absorbed compared with a travelling-wave pumping arrangement. That improvement over the travelling-wave arrangement decreases as the location of the element is moved away from the antinode and towards a node of the pump standing wave.

The invention provides a particular advantage when used with "in-well" pumping, where the pump energy is such that it is absorbed only in the quantum wells and therefore overall absorption is relatively low for the device (typically, for example, ~1% for each well). Thus, the element may be arranged such that pump light is absorbed in the same region of the active region as a region from which signal light is emitted. For example, the pump light may be absorbed at a transition within a quantum-well structure. For many devices, formation of a pump standing wave enables use of longer wavelength pump and therefore improved overall laser efficiency due to the lower quantum defect. Potentially the localised carrier concentration associated with 'in-well' pumping could lead to a device with a faster dynamic response time.

Alternatively, the element for interacting with light in the device may be a barrier region adjacent to a quantum well; such an arrangement is known as a 'barrier pumping' scheme.

With careful optimisation of absorber positions the resonant periodic gain of the device may also be maintained. Thus, the element may be arranged at or near an anti-node in the signal standing-wave and at or near an anti-node in the pump standing wave. For example, again, the element may be a quantum-well structure, which may be arranged at the anti-nodes of both standing waves and thus may provide both maximum pump-light absorption and maximum gain.

It will be understood that factors described above in respect of an aspect of the invention may be provided in any other aspect of the invention, unless that makes no physical sense.

Illustrative embodiments of the invention will now be described in detail by way of example with reference to the accompanying drawings in which:
Fig. 1 is a (a) a prior art VECSEL structure and (b) a prior art VCSEL structure;
Fig. 2 is a prior art VECSEL exhibiting resonant periodic gain;
Fig. 3 is an example of a (a) resonantly pumped and (b) antiresonantly pumped VECSEL device;
Fig. 4 is a schematic showing a standing-wave pump beam and a travelling-wave pump beam;
Fig. 5 is a schematic of two reflectors having two high-reflectance bands used in the device of Fig. 3;
Fig. 6 is another reflector, having two high-reflectance bands;
Fig. 7 is reflectivity spectra for (a) a mirror having two reflection bands and (b) a device incorporating the mirror.;
Fig. 8 is three reflectivity spectra showing reflectivity spectra of (a) a Fabry-Perot cavity having a discrete reflection band, (b) a Fabry-Perot cavity having a longer cavity than case (a) and (c) a Fabry-Perot cavity having a wider reflection band than in case (a).
Fig. 9 is an example of a device according to the invention.
Fig. 10 is an example of a VCSEL device according to the invention.
Fig. 11 is another example of a device according to the invention.
Fig. 12 is another example of a device according to the invention.

As discussed above, vertical cavity surface emitting semiconductor lasers and their derivatives are generally either grown monolithically on a substrate or formed through various processing steps (such as bonding and etching) and can include dielectric mirror coatings. They generally comprise a Distributed Bragg Reflector (DBR) mirror structure consisting of alternating quarter wavelength (optical thickness) layers of two or more optically transparent materials with a suitable refractive index contrast to provide a high degree of reflection at the signal (operating) wavelength. On top of this mirror, as described above, a semiconductor cavity or sub-cavity containing bulk, quantum well or quantum dot gain providing regions is fabricated. The optical thickness of this gain region is an integer number of quarter wavelengths (sub-cavity) or an integer number of half wavelengths (cavity) at the signal wavelength. For optimum device performance in the case of quantum wells or quantum dot active regions the wells or dot layers are surrounded by an appropriate thickness of "barrier" or spacer material to place them within the cavity at the oscillating laser field antinodes for maximum gain extraction efficiency, so-called resonant periodic gain (RPG). These layers in addition to providing carrier confinement, depending on their composition may also provide additional pump absorption (barrier pumping), as described above. The gain region or sub-cavity may also contain non-absorbing confinement regions at its edges in order to isolate carriers from parasitic recombination effects at the device surface and/or the mirror layers. Finally, in order to form a Fabry-Perot cavity, a top mirror reflection is provided either by a coated or grown DBR mirror or by the latent reflectivity of the air/semiconductor interface. The latter case (VECSEL) the surface reflection forms a weaker Fabry-Perot sub-cavity and the device requires an external mirror or mirror arrangement to form a laser resonator. A vertical cavity semiconductor optical amplifier (VCSOA) is simply a VCSEL operated in gain but below laser threshold or has laser operation frustrated in some way. Pump light is provided by lasers of suitable wavelength and is coupled to the device with suitable optics to provide a tight to moderate focus (typically 10-100um) at the surface of the VECSEL chip. The VCSEL, VCSOA or VECSEL chip may be mounted on a suitable temperature controlled heatsink.

The prior art structures of Figs. 1 and 2 have been discussed above.

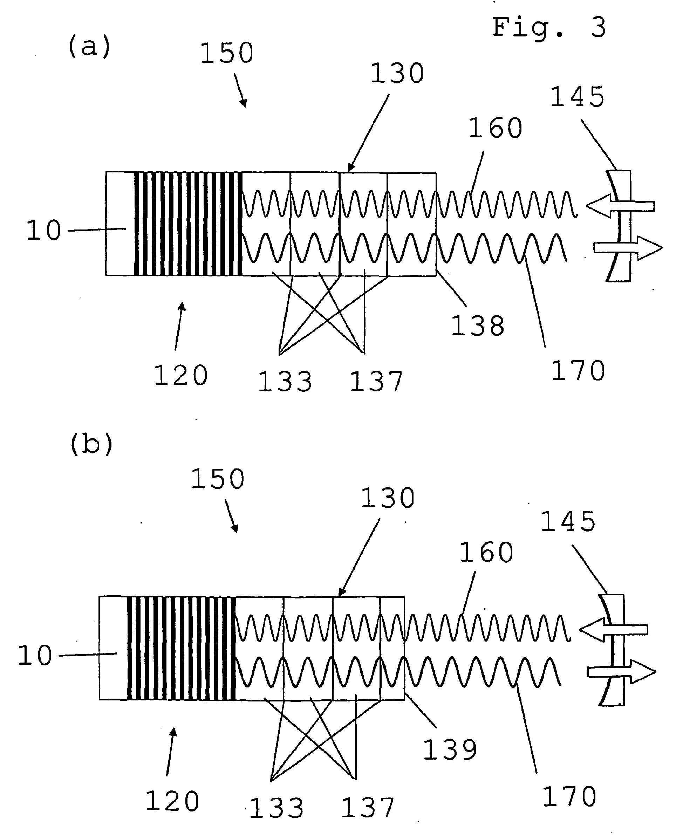

An example VECSEL (Fig. 3(a)) comprises a chip 150 comprising a bottom reflector 120, which is designed such that it exhibits a high degree of reflectivity at both the pump wavelength and at the signal (laser) wavelength. The VECSEL also comprises external mirror 145, which is highly reflective at the signal wavelength (in an alternative example, a plurality of mirrors replace mirror 145). Active region 130 comprises absorbing elements in the form of quantum wells 133 separated by barrier regions 137.

In use, pump light makes a first pass through active region 130 and is reflected at reflector 120. The reflected light interferes with the incident light and produces a standing wave 160. In this example, absorption of the pump light is by in-well pumping and so a significant amount of pump light remains after a second pass through the active region 130 (the typical single pass absorption of each quantum well 133 is ~1%). The pump light is then reflected at the air-semiconductor interface 138 at the top of the device, back towards mirror 120. (The pump beam is sufficiently wide for an overlap between the incident and reflected beam to occur even though the incident beam will usually not be normal to the interface.) A proportion of the pump light thus makes several passes of the active region 130 in forming the resonant standing wave 160.

In addition to the pump resonance, and as in the prior art, a standing wave 170 is also established in the signal beam by reflections from the mirrors 120, 145.

Barrier regions 137 have a thickness carefully selected to position quantum wells 133 at the antinodes of both the pump standing wave 160 and the signal standing wave 170, so as to enhance the absorption performance of the device, while maintaining RPG performance.

In the resonantly pumped VECSEL of Fig. 3(a), the pump wavelength matches a sub-cavity resonance (indicated by the maximum at surface 138 in the schematic pump field 160 of Fig. 3(a)).

In an alternative example (Fig. 3(b)), chip 150 is made to a different length, such that surface 139 is at a different distance (in this example, closer) to mirror 120 than surface 138 was. The VECSEL is in this case anti-resonantly pumped (that is, it is pumped at a wavelength between the resonant wavelengths of the Fabry-Perot cavity formed between mirror 120 and interface 139), indicated by a minimum at surface 139 in the schematic pump field 160 of Fig. 3(b). The signal field 170 is in this example resonant with this subcavity. Even though the pump field 160 is antiresonant with the Fabry-Perot cavity between mirrors 120, 139, pump field 160 nevertheless forms a standing wave in active region 130 due to reflection at mirror 120.

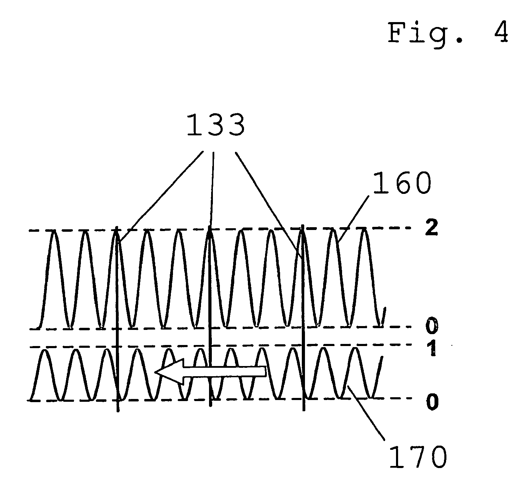

The pump absorption enhancement factor for a standing pump wave over the case of a travelling wave pump 180 (illustrated schematically in Fig. 4) is a product of the reflectivity of the lower mirror 120 (and hence varies from 1 to 2) and the absorption enhancement from the positioning of the wells 133 (which varies from 0 to 2, corresponding to all wells 133 at the nodes of the pump field 160 and all wells 133 at the antinodes respectively).

The reflection of both pump and signal can be achieved by engineering reflector 120 in any suitable way.

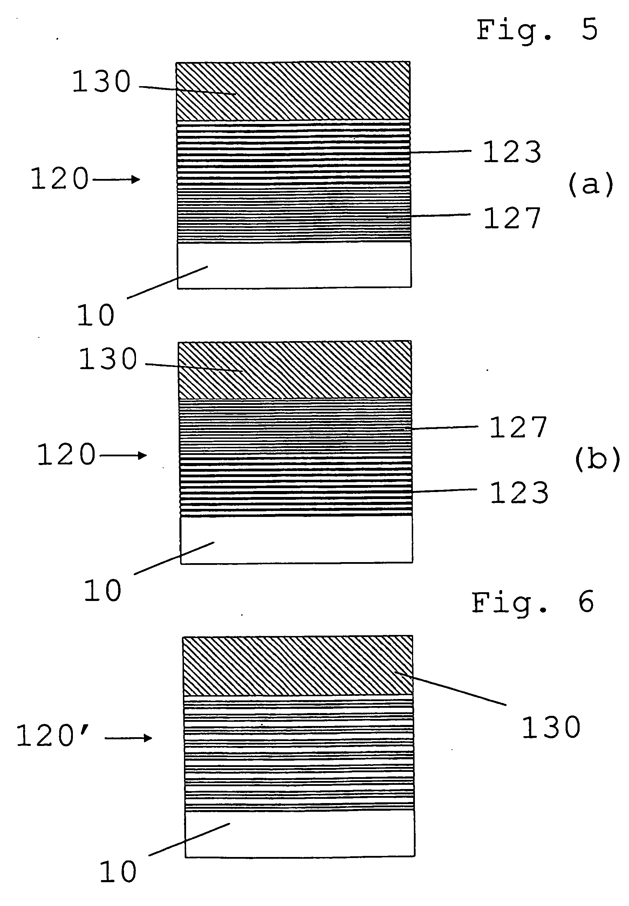

In the examples of Fig. 3, reflector 120 comprises two reflectors 123, 127 (Fig. 5(a)). One DBR 123 is for reflecting the signal and the second DBR 127 is for reflecting the pump. The pump mirror 127 is arranged at the bottom of the semiconductor stack (i.e. further than the signal mirror 123 from the active region 130).

In an alternative example (Fig. 5(b)), the mirrors are arranged the other way around, with the signal mirror 123 is arranged at the bottom of the semiconductor stack (i.e. further than the pump mirror 127 from the active region 130). This arrangement has the advantage that a saturable absorber may be arranged between the signal mirror 123 and the pump mirror 127, where it will not be exposed to pump light but will be able to affect signal light. This arrangement has the further advantage that, as the signal light must pass through the pump mirror 127, pump mirror 127 may be grown to have a selected effect on the signal light, for example the pump mirror may tailor the signal in some way, for example by affecting its spectrum.

In another alternative example (Fig. 6), reflector 120' comprises a double band DBR stack comprising alternating refractive index layers arranged in a pattern contains a simplified sub-structure which exhibits two reflection bands, one at the pump and one at the signal wavelength.

In an alternative example, computer optimisation of the individual layer thickness is carried out to provide the desired reflectivity profile.

Example structures for mirror 120' are shown in Figs. 5 and 6; however, similar structures could also or alternatively be used for external mirror 145 in a VECSEL or top mirror 40 of a VCSEL.

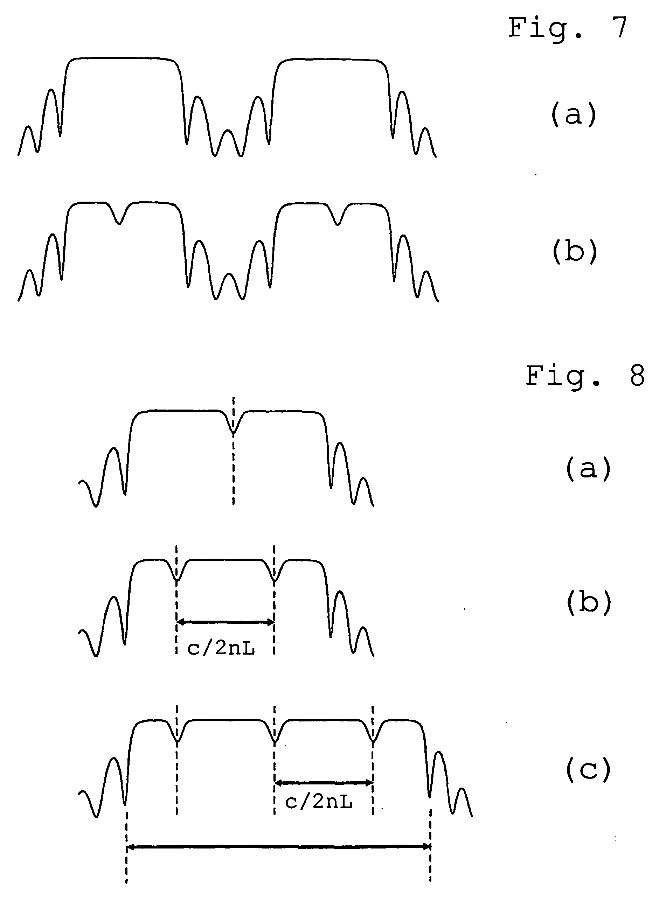

Fig. 7(a) shows the reflectivity spectrum of mirror 120. Two flat high-reflection bands are visible, with the pump wavelength falling within the shorter-wavelength band and the signal wavelength falling within the longer-wavelength band.

Fig. 7(b) shows the reflectivity spectrum and hence the Fabry-Perot resonances or modes of a pair of mirrors having reflectivity profiles as shown in Fig. 7(a). As is well known, a pair of partially reflecting surfaces separated by physical distance L exhibit transmissivity peaks having a separation in frequency of c/2nL, where c is the speed of light and n is the refractive index of the material between the surfaces (2nL is thus the roundtrip optical path length between the surfaces).

The reflectivity profile of Fig. 7(b) shows a deep trough near the middle of each of the broad band of frequencies at which the cavity is otherwise relatively highly reflecting.

As with the sub-cavity resonances at the signal wavelength in a VECSEL device, resonances at the pump for any optically pumped vertical emitter can be enhanced/removed or manipulated by careful design of the structure or by provision of suitable coatings on the structure.

Fig. 8(a) shows the reflectivity spectrum of a device having a pair of mirrors each having a single high-reflectance band. A resonance, due to reflection between the mirrors, appears within the band. In a further alternative example, the laser cavity or subcavity is grown to be sufficiently long that more than one of the Fabry-Perot resonances lie within the reflection band of the device (pumping at one of the lower of the resonances within a single mirror band is dubbed resonant 'close' pumping). The modes of this reflector, which are of course separated in frequency by c/2nL (with L in this case being longer than in the case of Fig. 8(a)), are shown in Fig. 8(b).

In a further alternative example, a similar close-pumping effect is achieved by creating a suitably wide reflectivity band, for example by an oxidation process. The modes of this reflector are shown in Figure 8(c). Again, the modes are separated in frequency by c/2nL; the increased width of the reflectivity band means that a shorter cavity length may be used than in the case of Fig. 8(b).

Combinations of these various forms of reflectors are also possible.

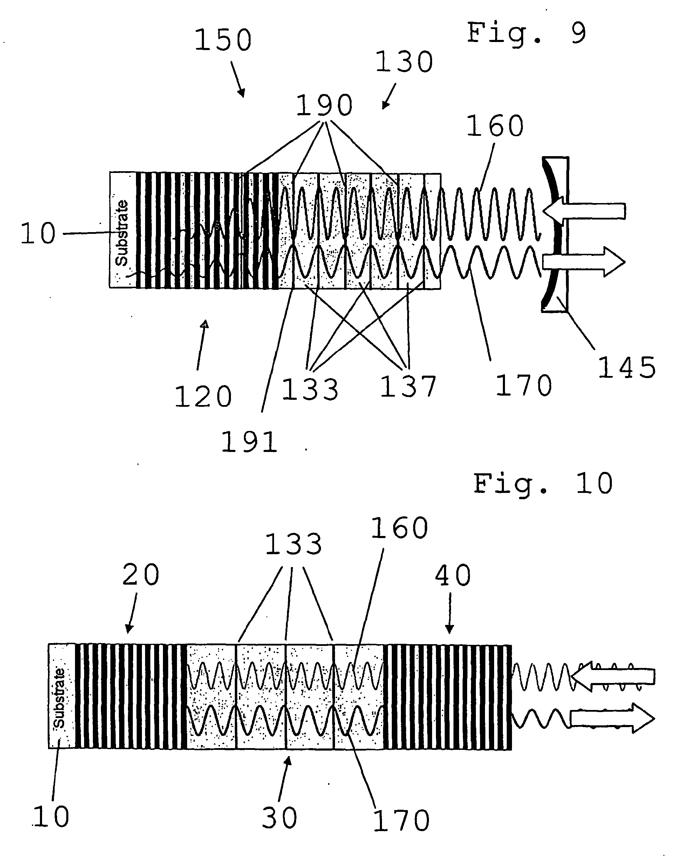

In an embodiment of the invention (Fig. 9), in addition to gain quantum wells 133 arranged at the antinodes of a pump standing wave 160 and a signal standing wave 170, a saturable absorber quantum well 191 is arranged at a node of the pump standing wave 160. (Nodes 190 of the pump standing wave are nodes which coincide with antinodes of the signal standing wave. However, in alternative embodiments of the invention, the absorber 191 may be arranged at a position, which is preferably at or near a node of the pump light, that does not coincide with an antinode of the signal standing wave.) The incorporation of a saturable absorber 191 at an optimised position within the laser structure enables pulsed operation by passive modelocking or gain switching element. Positioning the saturable absorber 191 at a node of the pump field 160 avoids pump saturation of the absorber 191. The absorber 191 is carefully arranged in the structure (by careful control of the thickness of barrier region 137 during growth of the structure) to allow maximum saturation by the signal 170 and minimal/zero exposure to the pump light 160. The absorber 191 must saturate before the gain provided by wells 133 saturates, in order to provide a preferential gain window for pulse production. In the prior art, a preferential gain window is usually achieved in, a device comprising a SESAM or SBR, by placing the quantum well at or near the surface of the SESAM or SBR and tightly focusing the signal field at the absorber. In an integrated device embodying the invention, there is more scope for positioning the absorber within the cavity or structure; however, to ensure maximum and rapid absorption, the RPG performance (i.e. the position of the gain wells) of the device may have to be compromised. Such an arrangement may provide, for example, gain switching in a VCSEL and modelocking in a VECSEL.

The invention is also applicable to other vertical-cavity devices.

Fig. 10 shows a VCSEL device of a form similar to that of Fig. 1(b). Pump and signal fields 160, 170 each form a standing wave between mirrors 20, 40. Quantum wells 133 provide gain in the device and are arranged at antinodes of both the pump field 160 and the signal field 170, thus providing resonant enhancement of both pump-light absorption and signal-light gain.

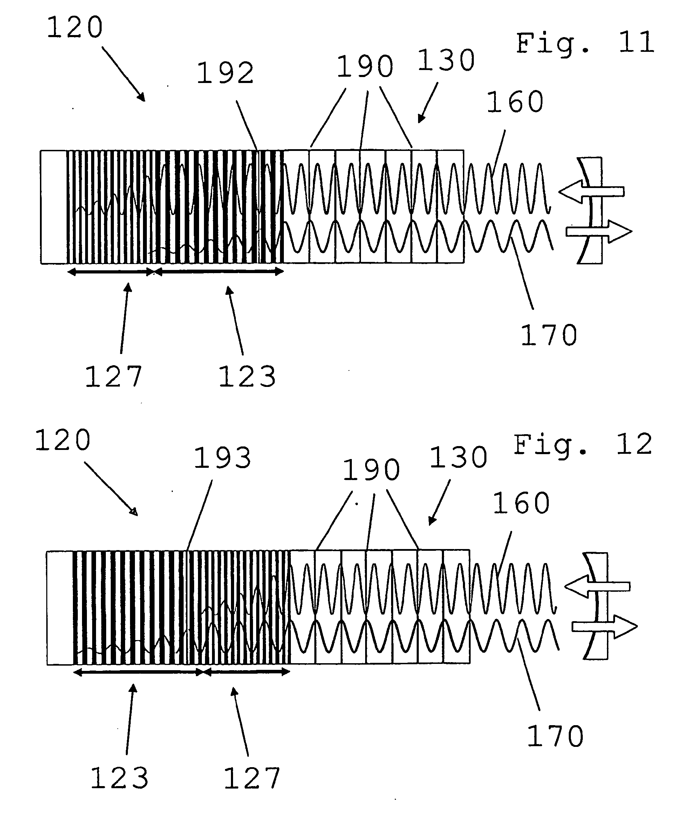

Fig. 11 shows a way in which the mirror of Fig. 5 (a) may be incorporated in a VECSEL. Pump mirror 127 is arranged behind signal mirror 123, that is, further from active region 130. Pump standing wave 160 therefore extends through signal mirror 123. Saturable absorber 192 is positioned at a pump node (and a signal antinode) within signal mirror 123.

Fig. 12 shows an alternative arrangement, incorporating the mirror of Fig. 5(b). In this case, the pump light 160 is reflected by mirror 127 in front of mirror 123, whereas signal light 170 passes through mirror 127 to mirror 123, which is further from active region 130 than mirror 127. In this case, saturable absorber 193 is arranged outside the pump standing wave 160, in mirror 123. (As far as saturable absorber 193 is concerned, there is of course no need for the pump light 160 to form a standing wave).

In some examples of embodiments of the invention, the front surface of chip 50 (i.e., the surface furthest from substrate 10 and mirror 120) is uncoated, coated with a custom mirror coating or antireflection coated.

## Claims

1. An optical device (150), comprising:
(a) an active semiconductor region (130), for providing gain to signal light (170) passing through said active region (130);
(b) a signal-light reflector (120), for reflecting the signal light (170) through the active region (130) in a direction out of the plane of the active region (130); and
(c) a pump-light reflector (120), the pump-light reflector (120) being arranged to reflect pump light (160) so as to form a standing wave in the device (150); and
(d) an absorber (191;192;193) that absorbs light at a wavelength of the signal light (170);
**characterised in that** the absorber (191;192;193) is arranged at a position in the device (150) at which there is no or substantially no pump light (160).

2. An optical device as claimed in claim 1, in which the active region (130), signal-light reflector (120), pump-light reflector (120) and absorber (191;192;193) are comprised in a monolithic unit.

3. An optical device as claimed in claim 1 or claim 2, in which the absorber (191;192) is arranged at or near a node in the pump standing wave (160).

4. An optical device as claimed in claim 3, in which the active region (130) comprises the absorber (191;192).

5. An optical device as claimed in claim 4, in which the signal light (170) forms a signal standing-wave by reflection from the signal-light reflector (120).

6. An optical device as claimed in claim 5, in which the absorber (191;192;193) is arranged at or near an anti-node in the signal standing-wave (170).

7. An optical device as claimed in any preceding claim, comprising a second device for interacting with light, comprising a gain element (133) that absorbs the pump light (160) to provide gain to the signal light (170).

8. An optical device as claimed in claim 7, in which the pump-light-absorbing element (133) is arranged at or near an anti-node in the signal standing wave (170).

9. An optical device as claimed in any preceding claim, in which the signal-light reflector (120) comprises a metal or semiconductor mirror or a dielectric stack.

10. An optical device as claimed in any preceding claim, in which the pump-light reflector (120) comprises a metal or semiconductor mirror or a dielectric stack.

11. An optical device as claimed in any preceding claim, comprising a second pump-light reflector (145) for reflecting the pump light back towards the pump-light reflector.

12. An optical device as claimed in claim 11, in which the second pump-light reflector (145) comprises a metal mirror or a dielectric stack.

13. An optical device as claimed in any preceding claim, being a monolithic or composite laser structure fabricated with a bottom Bragg reflector (120) that reflects the pump (160) and signal (170), such that that the pump field (160) forms a standing wave.

14. An optical device as claimed in any preceding claim, in which the pump-light reflector and the signal-light reflector are comprised in a single reflector (120).

15. An optical device as claimed in any preceding claim, comprising a second signal-light reflector (145) for reflecting the signal light (170) back towards the signal-light reflector (120).

16. An optical device as claimed in claim 15, in which the second signal-light reflector (145) comprises a metal mirror stack.

17. An optical device as claimed in claim 15 or 16, in which reflections from at least the signal-light reflector (120) and the second signal-light reflector (145) result in a cavity or sub-cavity resonance at a signal wavelength at which the active region (150) provides gain, further comprising a source of pump light (160) at a pump wavelength, wherein the signal-light reflector (120) also reflects pump light (160) at the pump wavelength.

18. An optical device as claimed in claim 17, in which reflections from at least the signal-light reflector (120) and the second signal-light reflector (145) result in a cavity or sub-cavity resonance at the pump wavelength.

19. An optical device as claimed in any preceding claim, the device being arranged to provide pulses of signal light.

## Patentansprüche

1. Eine optische Vorrichtung (150), umfassend:
(a) einen aktiven Halbleiterbereich (130), um einem Signallicht (170), welches den aktiven Bereich (130) durchläuft, eine Verstärkung bereitzustellen;
(b) einen Signallichtreflektor (120), um das Signallicht (170) durch den aktiven Bereich (130) hindurch in eine Richtung aus der Ebene des aktiven Bereichs (130) heraus zu reflektieren ; und
(c) einen Pumplichtreflektor (120), wobei der Pumplichtreflektor (120) angeordnet ist, um Pumplicht (160) so zu reflektieren, um eine stehende Welle in der Vorrichtung (150) zu bilden: und
(d) einen Absorber (191; 192; 193), welcher Licht bei einer Wellenlänge des Signallichts (170) absorbiert;
**dadurch gekennzeichnet, dass** der Absorber (191; 192; 193) an einer Position in der Vorrichtung (150) angeordnet ist, an welcher kein oder im Wesentlich kein Pumplicht (160) vorhanden ist.

2. Eine optische Vorrichtung nach Anspruch 1, wobei der aktive Bereich (130), der Signallichtreflektor (120), der Pumplichtreflektor (120) und der Absorber (191; 192; 193) in einer monolithischen Einheit enthalten sind.

3. Eine optische Vorrichtung nach Anspruch 1 oder Anspruch 2, wobei der Absorber (191; 192) an oder nahe einem Knoten in der stehenden Pumpwelle (160) angeordnet ist.

4. Eine optische Vorrichtung nach Anspruch 3, wobei der aktive Bereich (130) den Absorber (191; 192) umfasst.

5. Eine optische Vorrichtung nach Anspruch 4, wobei das Signallicht (170) durch Reflektion von dem Signallichtreflektor (120) eine stehende Signalwelle bildet.

6. Eine optische Vorrichtung nach Anspruch 5, wobei der Absorber (191; 192; 193) an oder nahe einem Wellenbauch in der stehenden Signalwelle (170) angeordnet ist.

7. Eine optische Vorrichtung nach einem der vorhergehenden Ansprüche, umfassend eine zweite Vorrichtung zum Interagieren mit Licht, umfassend ein Verstärkungselement (133), welches das Pumplicht (160) absorbiert, um dem Signallicht (170) eine Verstärkung bereitzustellen.

8. Eine optische Vorrichtung nach Anspruch 7, wobei das Pumplicht absorbierende Element (133) an oder nahe einem Wellenbauch in der stehenden Signalwelle (170) angeordnet ist.

9. Eine optische Vorrichtung nach einem der vorhergehenden Ansprüche, wobei der Signallichtreflektor (120) einen Metall- oder Halbleiterspiegel oder einen dielektrischen Stapel umfasst.

10. Eine optische Vorrichtung nach einem der vorhergehenden Ansprüche, wobei der Pumplichtreflektor (120) einen Metall- oder Halbleiterspiegel oder einen dielektrischen Stapel umfasst.

11. Eine optische Vorrichtung nach einem der vorhergehenden Ansprüche, umfassend einen zweiten Pumplichtreflektor (145) zum Reflektieren des Pumplichts zurück in Richtung auf den Pumplichtreflektor.

12. Eine optische Vorrichtung nach Anspruch 11, wobei der zweite Pumplichtreflektor (145) einen Metallspiegel oder einen dielektrischen Stapel umfasst.

13. Eine optische Vorrichtung nach einem der vorhergehenden Ansprüche, wobei sie eine monolithische oder zusammengesetzte Laserstruktur ist, welche mit einem Braggschen Bodenreflektor (120) hergestellt wird, der das Pumplicht (160) und das Signallicht (170) reflektiert, so dass das Pumpfeld (160) eine stehende Welle bildet.

14. Eine optische Vorrichtung nach einem der vorhergehenden Ansprüche, wobei der Pumplichtreflektor und der Signallichtreflektor in einem einzigen Reflektor (120) enthalten sind.

15. Eine optische Vorrichtung nach einem der vorhergehenden Ansprüche, umfassend einen zweiten Signallichtreflektor (145) zum Reflektieren des Signallichts (170) zurück in Richtung auf den Signallichtreflektor (120).

16. Eine optische Vorrichtung nach Anspruch 15, wobei der zweite Signallichtreflektor (145) einen Metallspiegelstapel umfasst.

17. Eine optische Vorrichtung nach Anspruch 15 oder 16, wobei Reflektionen von mindestens dem Signallichtreflektor (120) und dem zweiten Signallichtreflektor (145) zu einer Hohlraum- oder Subhohlraumresonanz führen, bei einer Signalwellenlänge, bei welcher der aktive Bereich (150) eine Verstärkung bereitstellt, des Weiteren umfassend eine Quelle von Pumplicht (160) mit einer Pumpwellenlänge, wobei der Signallichtreflektor (120) auch Pumplicht (160) mit der Pumpwellenlänge reflektiert.

18. Eine optische Vorrichtung nach Anspruch 17, wobei Reflektionen von mindestens dem Signallichtreflektor (120) und dem zweiten Signallichtreflektor (145) zu einer Hohlraum- oder Subhohlraumresonanz bei der Pumpwellenlänge führen.

19. Eine optische Vorrichtung nach einem der vorausgehenden Ansprüche, wobei die Vorrichtung angeordnet ist, um Signallicht-Impulse zu erzeugen.

## Revendications

1. Dispositif optique (150), comprenant :
(a) une région semi-conductrice active (130), pour fournir un gain à un signal lumineux (170) traversant ladite région active (130) ;
(b) un réflecteur de signal lumineux (120), pour réfléchir le signal lumineux (170) à travers la région active (130) suivant une direction hors du plan de la région active (130) ; et
(c) un réflecteur de lumière de pompage (120), le réflecteur de lumière de pompage (120) étant agencé de façon à réfléchir la lumière de pompage (160) afin de former une onde stationnaire dans le dispositif (150) ; et
(d) un dispositif d'absorption (191 ; 192 ; 193) qui absorbe de la lumière à une longueur d'onde du signal lumineux (170) ;
**caractérisé en ce que** le dispositif d'absorption (191 ; 192 ; 193) est agencé à une position dans le dispositif (150) au niveau de laquelle il n'y a pas ou sensiblement pas de lumière de pompage (160).

2. Dispositif optique selon la revendication 1, dans lequel la région active (130), le réflecteur de signal lumineux (120), le réflecteur de lumière de pompage (120) et le dispositif d'absorption (191 ; 192 ; 193) sont compris dans une unité monolithique.

3. Dispositif optique selon la revendication 1 ou 2, dans lequel le dispositif d'absorption (191 ; 192) est agencé au niveau d'un noeud ou à proximité de celui-ci dans l'onde stationnaire de pompage (160).

4. Dispositif optique selon la revendication 3, dans lequel la région active (130) comprend le dispositif d'absorption (191; 192).

5. Dispositif optique selon la revendication 4, dans lequel le signal lumineux (170) forme une onde stationnaire de signal par une réflexion depuis le réflecteur de signal lumineux (120).

6. Dispositif optique selon la revendication 5, dans lequel le dispositif d'absorption (191 ; 192 ; 193) est agencé au niveau ou à proximité d'un anti-noeud dans l'onde stationnaire de signal (170).

7. Dispositif optique selon l'une quelconque des revendications précédentes, comprenant un second dispositif pour agir conjointement avec la lumière, comprenant un élément de gain (133) qui absorbe la lumière de pompage (160) afin de fournir un gain au signal lumineux (170).

8. Dispositif optique selon la revendication 7, dans lequel l'élément d'absorption de lumière de pompage (133) est agencé au niveau ou à proximité d'un anti-noeud dans l'onde stationnaire de signal (170).

9. Dispositif optique selon l'une quelconque des revendications précédentes, dans lequel le réflecteur de signal lumineux (120) comprend un miroir métallique ou semi-conducteur ou un faisceau diélectrique.

10. Dispositif optique selon l'une quelconque des revendications précédentes, dans lequel le réflecteur de lumière de pompage (120) comprend un miroir métallique ou semi-conducteur ou un faisceau diélectrique.

11. Dispositif optique selon l'une quelconque des revendications précédentes, comprenant un second réflecteur de lumière de pompage (145) pour réfléchir la lumière de pompage en retour vers le réflecteur de lumière de pompage.

12. Dispositif optique selon la revendication 11, dans lequel le second réflecteur de lumière de pompage (145) comprend un miroir métallique ou un faisceau diélectrique.

13. Dispositif optique selon l'une quelconque des revendications précédentes, étant une structure laser monolithique ou composite fabriquée avec un réflecteur de Bragg inférieur (120) qui réfléchit la pompe (160) et le signal (170) de sorte que le champ de pompage (160) forme une onde stationnaire.

14. Dispositif optique selon l'une quelconque des revendications précédentes, dans lequel le réflecteur de lumière de pompage et le réflecteur de signal lumineux sont compris dans un seul réflecteur (120).

15. Dispositif optique selon l'une quelconque des revendications précédentes comprenant un second réflecteur de signal lumineux (145) pour réfléchir le signal lumineux (170) en retour vers le réflecteur de signal lumineux (120).

16. Dispositif optique selon la revendication 15, dans lequel le second réflecteur de signal lumineux (145) comprend une pile de miroir métallique.

17. Dispositif optique selon la revendication 15 ou 16, dans lequel les réflexions provenant d'au moins le réflecteur de signal lumineux (120) et le second réflecteur de signal lumineux (145) entraînent une résonance de cavité ou de sous-cavité à une longueur d'onde de signal à laquelle la région active (150) fournit un gain, comprenant en outre une source de lumière de pompage (160), à une longueur d'onde de pompage, dans lequel le réflecteur de signal lumineux (120) réfléchit également la lumière de pompage (160) à la longueur d'onde de pompage.

18. Dispositif optique selon la revendication 17, dans lequel les réflexions provenant d'au moins le réflecteur de signal lumineux (120)' et le second réflecteur de signal lumineux (145) entraînent une résonance de cavité ou de sous-cavité à la longueur d'onde de pompage.

19. Dispositif optique selon l'une quelconque des revendications précédentes, le dispositif étant agencé afin de fournir des impulsions de signal lumineux.
